# EUROPEAN PATENT APPLICATION

(11) **EP 1 837 912 A1**
(43) Date of publication of application: **26.09.2007**
(21) Application number: 06111568.9
(22) Date of filing: 22.03.2006
(51) Int. Cl.: H01L 27/32

(54) **Organic electroluminescent device and fabrication methods thereof**

(71) Applicant: Toppoly Optoelectronics Corp., Chu-Nan 350, Miao-Li County (TW)
(72) Inventor: Tseng, Chang-Ho, 327, Taoyuan County (TW); Peng, Du-Zen, 302, Hsinchu County (TW); Tsai, Yaw-Ming, 414, Taichung County (TW)
(74) Representative: Patentanwälte Kewitz & Kollegen

(57) **Abstract**

An organic electroluminescent device is disclosed. A substrate comprises a control area and a sensitive area. A switch device and a driving device are disposed overlying the control area. A photo diode is disposed overlying the sensitive area. An OLED element is disposed in the sensitive area and illuminates the photo diode. A capacitor is coupled to the photo diode and the driving device. A photo current corresponding to a brightness of the OLED element is generated by the photo diode responsive to the OLED element illuminating the photo diode such that a the voltage of the capacitor is adjusted by the photo current to control the current passing through the driving device, thus changing the illumination of the OLED element.

## Description

### BACKGROUND OF INVENTION

The present invention relates to an organic electroluminescent device and fabrication methods thereof.

Organic electroluminescent devices are also known as organic light emitting diodes (OLED). The OLED luminescent principle applies a voltage to organic molecular material or polymer material, and the device emits light. Due to a self emission characteristics of the OLED, dot matrix type displays with light weight, slim profile, high contrast, low power consumption, high resolution, fast response time, no need for backlighting, and wide viewing angle can be obtained. Possible display parameters range from 4mm microdisplay to 100 inch outdoor billboards makes it a preferred type of flat panel display (FPD). OLEDs with luminous efficiency over 100Lm/W can replace conventional lighting.

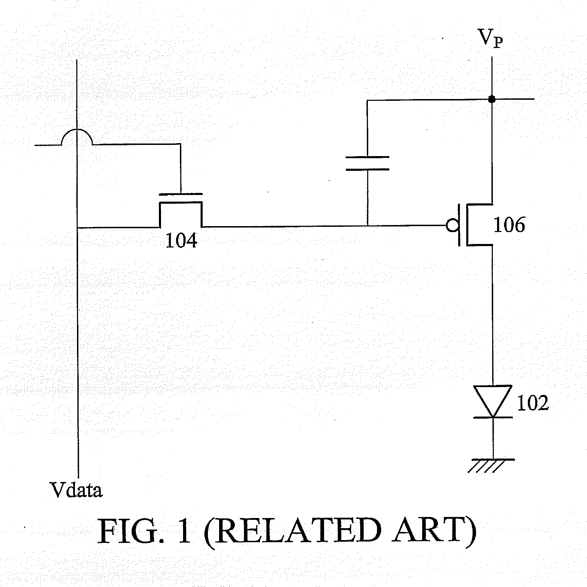

Referring to FIG. 1, an organic electroluminescent device 102 is operated by a switch transistor 104, and a driving transistor 106 coupling to a power line Vp. Organic electroluminescent devices 102, however, suffer from non-uniform brightness between pixels. Specifically brightness is decayed when the organic electroluminescent device 102 is operated for a long period.

### SUMMARY OF INVENTION

These and other problems are generally solved or circumvented, and technical advantages are generally achieved, by preferred illustrative embodiments of the present invention which provide an organic electroluminescent device.

An embodiment of the invention provides an organic electroluminescent device. A substrate comprises a control area and a sensitive area. A switch device and a driving device are disposed overlying the control area. A photo diode is disposed overlying the sensitive area. An OLED element is disposed in the sensitive area and illuminates the photo diode. A capacitor is coupled to the photo diode and the driving device. A photo current corresponding to a brightness of the OLED element is generated by the photo diode responsive to the OLED element illuminating the photo diode such that a the voltage of the capacitor is adjusted by the photo current to control the current passing through the driving device, thus changing the illumination of the OLED element.

According to one embodiment of the present invention, the switch device and the driving device are top gate transistors. The switch device has a first gate, the driving device has a second gate, and the photo diode has a first electrode connecting to the first type semiconductor layer. The first gate of the switch device, the second gate of the driving device, and the first electrode of the photo diode are formed of the same layer.

An embodiment of the invention further provides a method for forming an organic electroluminescent device. A substrate comprising a control area and a sensitive area is provided. A gate dielectric layer is formed on the substrate. A conductive layer is formed on the gate dielectric layer. The conductive layer is patterned to form first and second gates in the control area, and a first electrode layer in the sensitive area. A first dielectric layer is formed at least covering the first gate, the second gate, and the first electrode layer. The first dielectric layer is patterned to form an opening down to the first electrode in the sensitive area. A junction layer is formed in the opening overlying the sensitive area. An OLED element is formed overlying a portion of the control area and the sensitive area.

### BRIEF DESCRIPTION OF THE DRAWINGS

The invention can be more fully understood by reading the subsequent detailed description and examples with references made to the accompanying drawings, wherein:
FIG. 1 shows a conventional circuit diagram of an organic electroluminescent device.
FIG. 2 shows a pixel element of an organic electroluminescent device with compensating device in accordance with an embodiment of the invention.
FIG. 3A~FIG. 30 shows intermediate cross sections of a pixel element of an organic electroluminescent device with compensating device in accordance with an embodiment of the invention.
Fig. 4 shows a pixel element incorporated into an electronic device.

### DETAILED DESCRIPTION OF EXAMPLARY EMBODIMENTS

Embodiments of the invention, which provides an organic electroluminescent device, will be described in greater detail by referring to the drawings that accompany the invention. It is noted that in the accompanying drawings, like and/or corresponding elements are referred to by like reference numerals. The following description discloses the best-contemplated mode of carrying out the invention. This description is made for the purpose of illustrating the general principles of the invention and should not be taken in a limiting sense. The scope of the invention is best determined by reference to the appended claims.

In this specification, expressions such as "overlying the substrate", "above the layer", or "on the film" simply denote a relative positional relationship with respect to the surface of the base layer, regardless of the existence of intermediate layers. Accordingly, these expressions may indicate not only the direct contact of layers, but also, a non-contact state of one or more laminated layers.

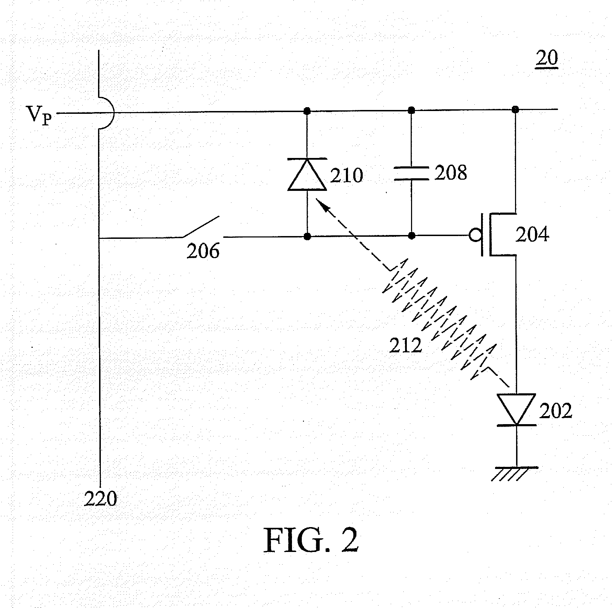

FIG. 2 shows an organic electroluminescent device with compensation device in accordance with an embodiment of the invention. Referring to FIG. 2, the organic electroluminescent device includes a pixel element 20. In the pixel element 20, an organic electroluminescent device 202 is operated by a switch device 206, such as switch integrated circuit(IC) or switch transistor, and a driving device 204 coupling to a power line Vp, also referred to as a driving integrated circuit, driving IC, in which current passing through the driving device 204 is controlled to determine illumination of the organic electroluminescent element 202. The switch device 206 is controlled by a column data line 220 and a row scan line. In an embodiment of the invention, a capacitor 208 can be coupled to a gate electrode of the driving device 204, in which the capacitor 208 further couples to a photo sensor 210. In an embodiment of the invention, the photo sensor 210 is a vertical photo diode. Voltage of the capacitor 208 is adjusted to control the current passing through the driving device according to illumination of the organic electroluminescent element 202 detected by the photo sensor 210, thus, illumination of the organic electroluminescent element 202 is changed for compensation.

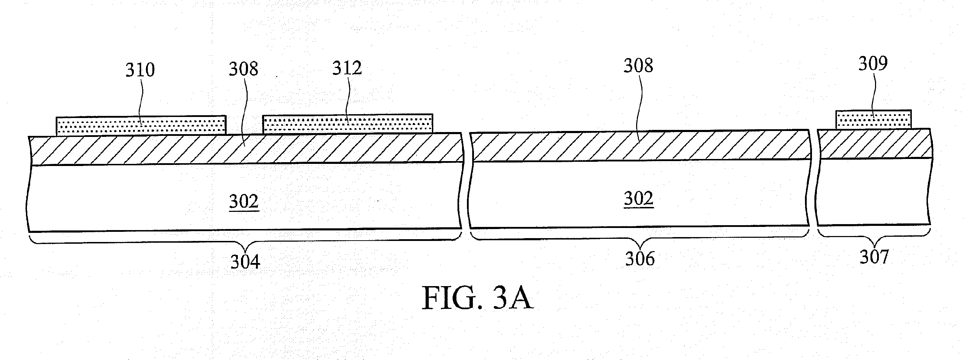

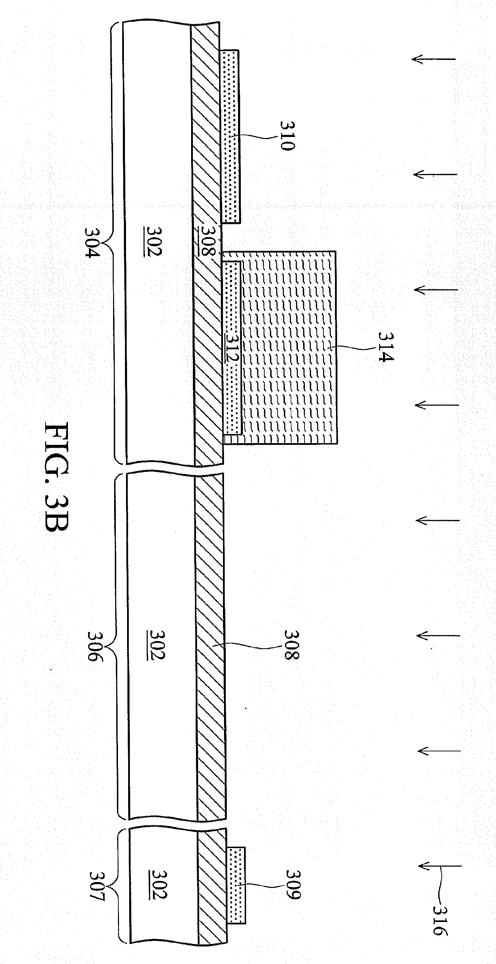

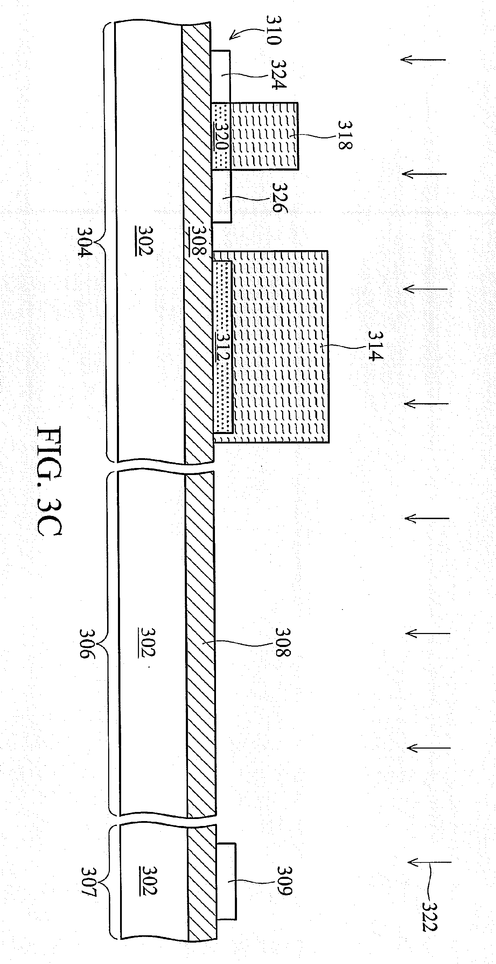

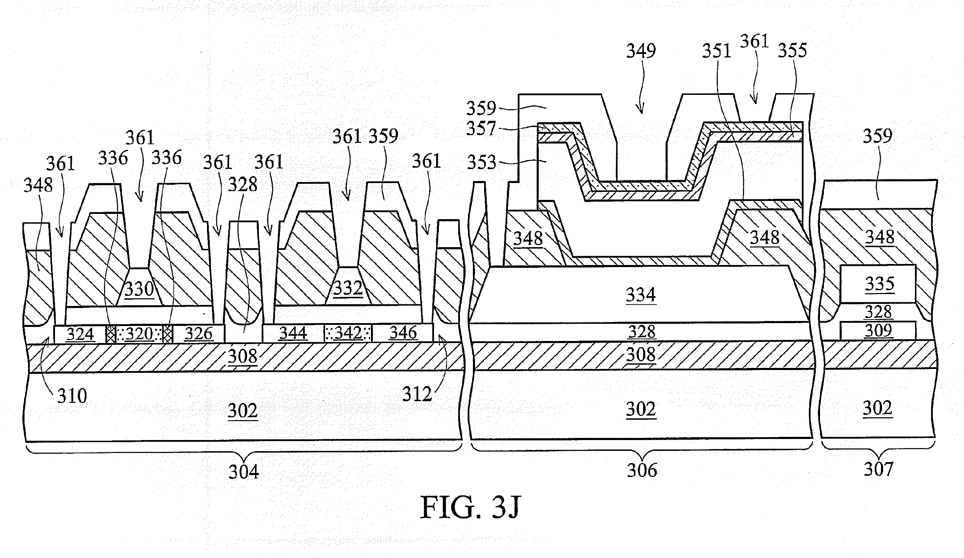

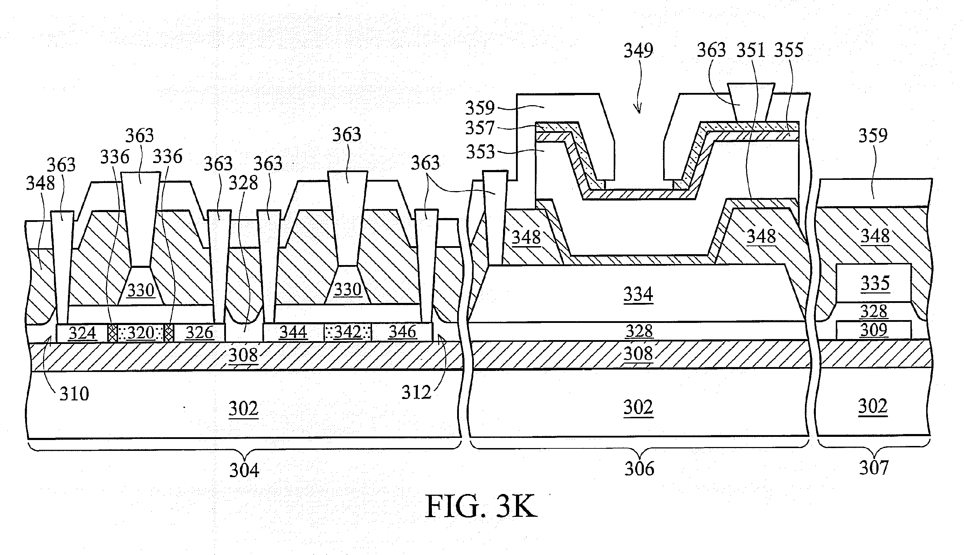

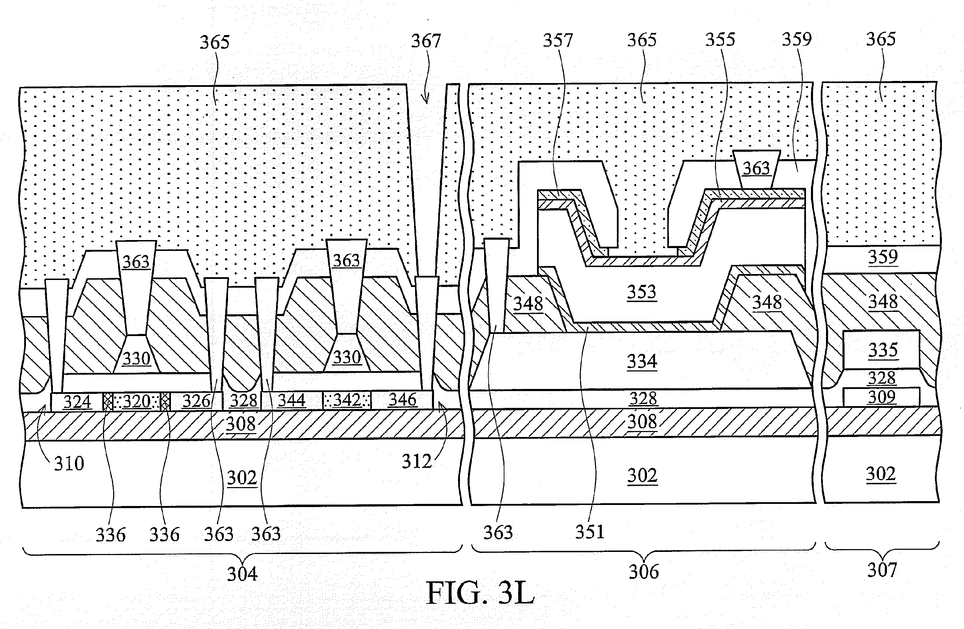

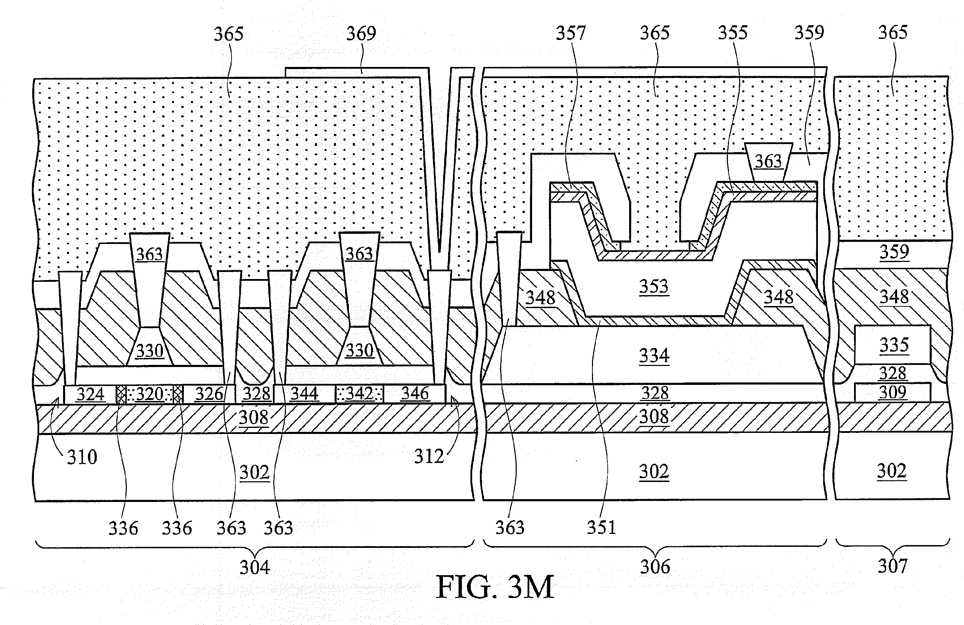

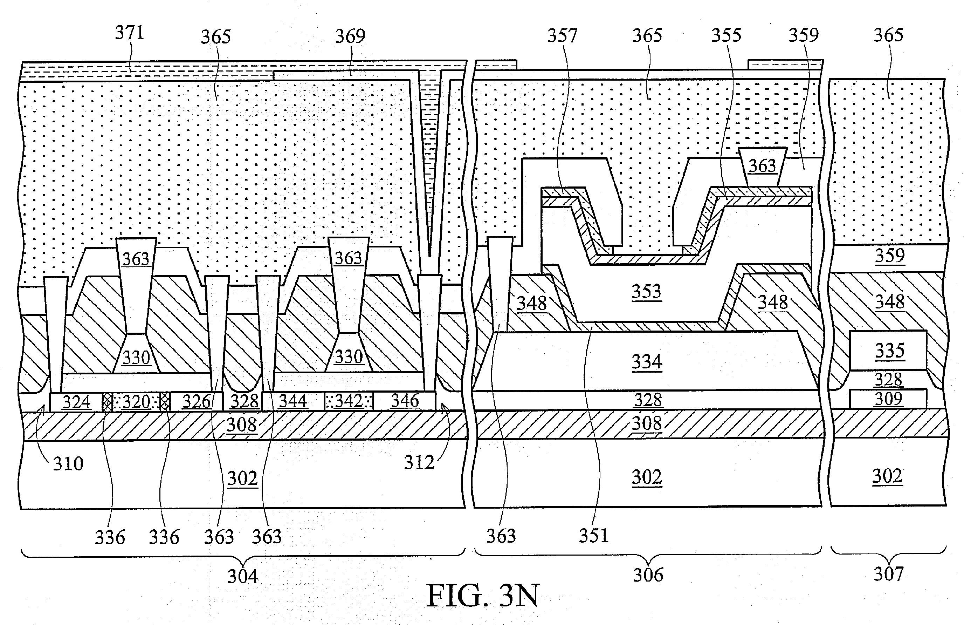

FIG. 3A~FIG. 30 shows an intermediate cross section of a pixel element 20 of an organic electroluminescent device with compensation device in accordance with an embodiment of the invention. Referring to FIG. 3A, a substrate 302 comprising a control area 304, a sensitive area 306 and a capacitor area 307 is provided, and a buffer layer 308 is formed on the substrate 302. The buffer layer 308 can comprise silicon oxide, silicon nitride, silicon oxynitride or a combination thereof, and preferably is a stack of a silicon oxide layer and a silicon nitride layer. In an embodiment of the invention, thickness of the silicon nitride layer can be about 350Å~650Å, and thickness of the silicon oxide layer can be about 1000Å~1600Å.

Next, a conductive layer (not shown) is formed on the buffer layer. The conductive layer can comprise polysilicon. For example, an amorphous silicon layer is first formed by deposition with chemical vapor deposition and then crystallized or annealed with excimer laser (ELA). The conductive layer is defined by conventional lithography and etched to form a first active layer 310 and a second active layer 312 overlying the control area 304 of the substrate 302, and a bottom electrode layer 309 overlying the capacitor area 307 of the substrate 302, in which a portion of the conductive layer overlying the sensitive area 306 is removed.

Referring to FIG. 3B, the second active layer 312 is covered by a photoresist layer 314 to channel dope dopant 316 into the first active layer 310, in which the dopant 316 thereof can comprise B+, and the dosage is typically about 0~1E13/cm2. Referring to FIG. 3C, a channel region 320 of the first active layer 310 is covered by another photoresist layer 318, implanting N+ ions 322 into the first active area 310 to form a source 324 and a drain 326 of a n type transistor. In an embodiment of the invention, the N+ ions may comprise phosphorous, and the dosage is preferably about 1E14~1E16cm2. Also, the bottom electrode layer 309 becomes n-doped.

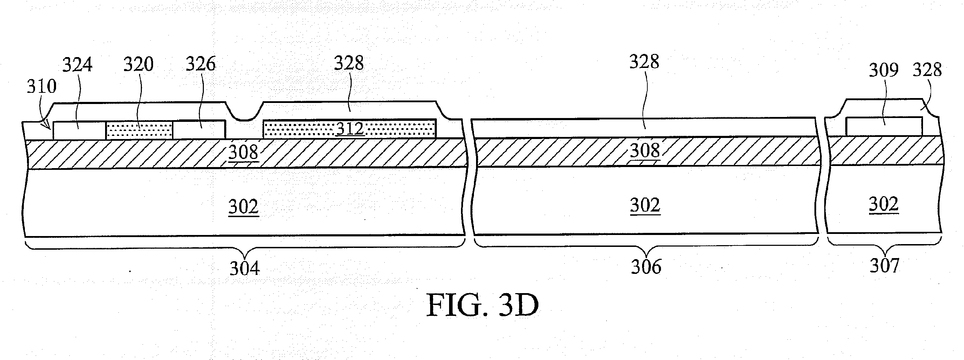

Referring to FIG. 3D, the photoresist layers 314 and 318 and are removed, and a gate dielectric layer 328, for example silicon oxide, silicon nitride, silicon oxynitride, a combination thereof, a stack layer thereof or other high K dielectric material, is blanketly deposited on the first active layer 310, the second active layer 312, the buffer layer 308 in the control area 304, and the bottom electrode layer 309 in the capacitor area 307, in which the gate dielectric layer 328 serves as a capacitor dielectric layer in the capacitor area 307.

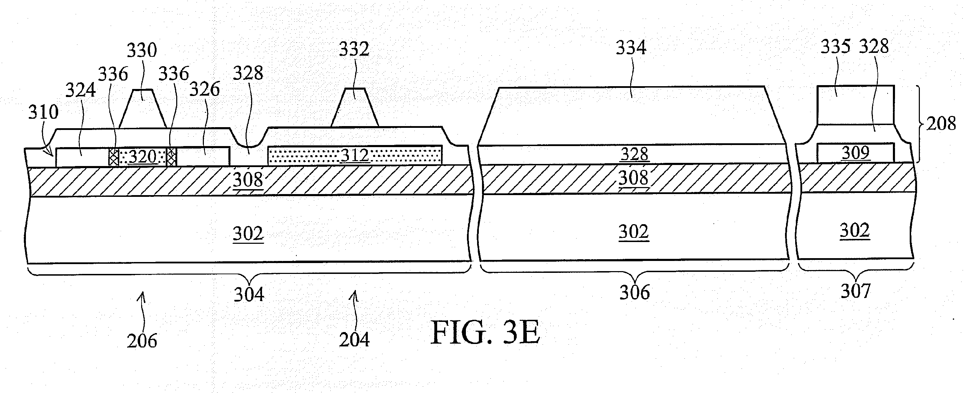

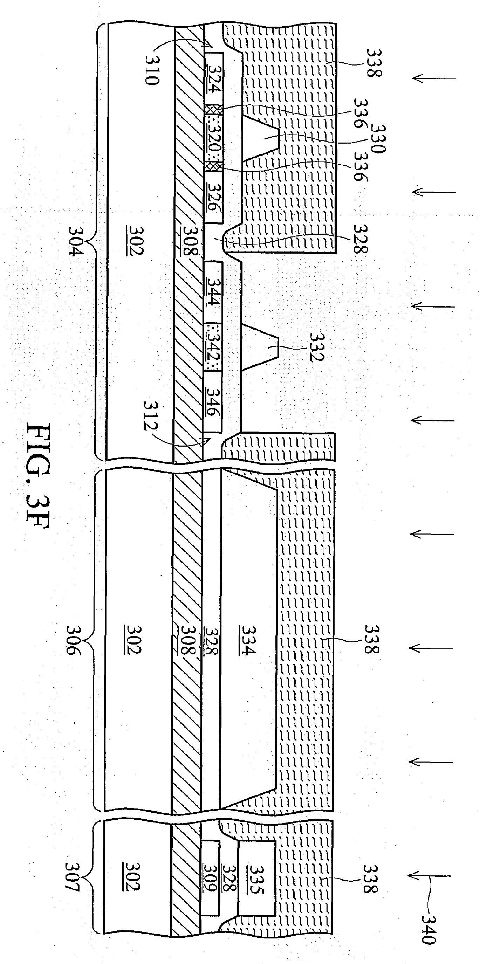

Referring to FIG. 3E, a gate conductive layer (not shown), for example doped polysilicon or metal, is formed on the gate dielectric layer 328. In an embodiment of the invention, the gate conductive layer is Mo and about 1500Å ~2500Å thick.

Next, the gate conductive layer is patterned by conventional lithography and etching to form a first gate 330 (n type transistor gate) overlying the first active layer 310, a second gate 332 (p type transistor gate) overlying the second active layer 312, a first electrode 334 on the gate dielectric layer 328 overlying the sensitive area 306, and a top electrode 335 overlying the capacitor area 307. Thus, the bottom electrode 309, the gate dielectric layer 328, and the top electrode 335 constitute the capacitor 208 as shown in FIG. 2.

In an embodiment of the invention, subsequent to formation of n type transistor gate 330, p type transistor gate 332 and first electrode 334, a light doping step, for example ion implantation, can be performed to form lightly doped source/drain (LDD) 336 on opposite sides of the channel region 320 of the first active layer 310 of n type transistor. Thus, the switch device 206 of n type and the driving device 204 of p type as shown in FIG. 2 are formed in the control area 304. According to some embodiments of the present invention, the switch device 206 and the driving device 204 are top gate transistors.

In FIG. 3F, a photoresist layer 338 is formed to cover the first active layer 310, the first electrode 334 in the sensitive area 306, and the top electrode 335 in the capacitor area 307. Thereafter, an ion implantation 340 is performed to form source 344 and drain 346 on opposite sides of the channel region 342 of the p type transistor.

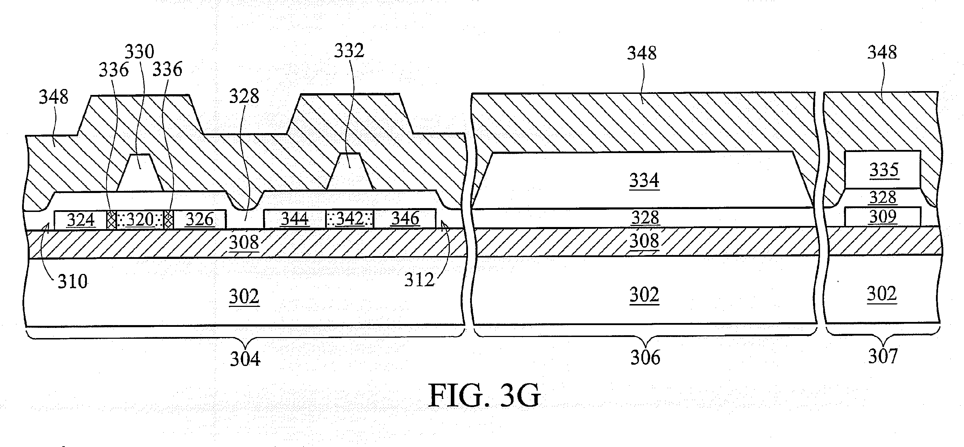

Next, referring to FIG. 3G, the photoresist layer 338 is removed, and a first dielectric layer 348 is blanketly deposited on the gate dielectric layer 328, the n type transistor gate 330 and the p type transistor gate 332 overlying the control area 304, the first electrode 334 overlying the sensitive area 306, and the top electrode 335 overlying the capacitor area 307.

Generally, thickness and composition of the first dielectric layer 348 can be determined according to product spec or process window. For example, the first dielectric layer 348 may include silicon dioxide, polyimide, spin-on-glass (SOG), fluoride-doped silicate glass (FSG), amorphous fluorinated carbon, and/or other materials. In an embodiment of the invention, the first dielectric layer 348 is a stack layer of silicon oxide and silicon nitride. For example, the first dielectric layer 348 can be a lower nitride layer/oxide layer/higher nitride layer structure, in which the lower nitride layer can be about 2500~3500Å thick, the oxide layer can be about 2500~3500Å thick and the higher nitride layer can be about 500~1500Å thick.

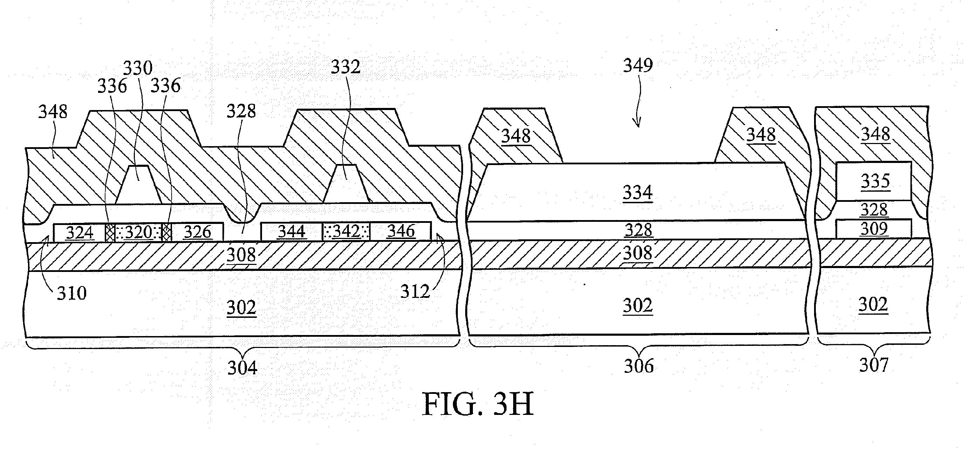

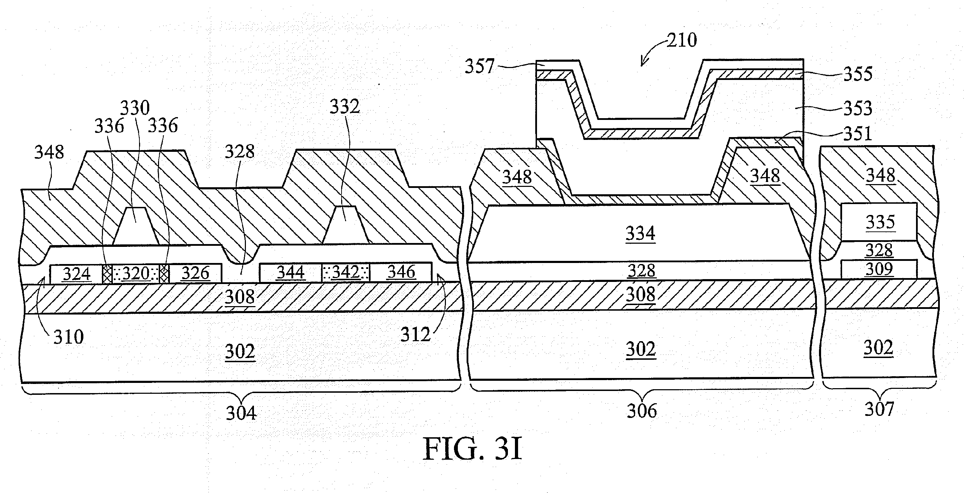

Referring to FIG. 3H, the first dielectric layer 348 is patterned by conventional lithography and etching to form an opening 349 exposing the first electrode 334 overlying the sensitive area 306.

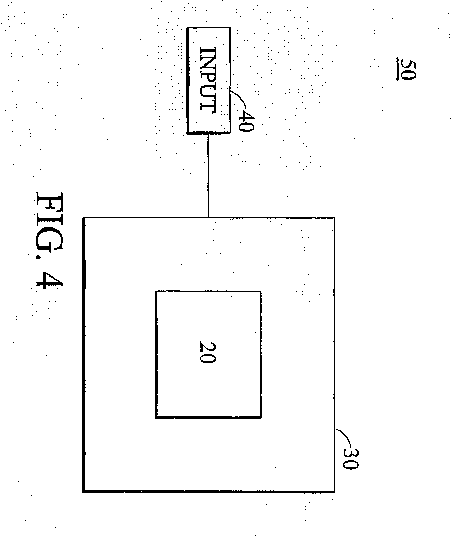

Referring to FIG. 31, a junction layer is formed on the first dielectric layer 348 and the first electrode 334. The junction layer can comprise a first type semiconductor layer 351, a second type semiconductor layer 353, and a third type semiconductor layer 355 in sequence. Then, a conductive contact layer 357 is formed. Then, the first, second, and third type semiconductor layers 351, 353, and 355, and the conductive contact layer 357 are patterned by conventional lithography and etching to remove the portion beyond the sensitive area 306.

The first type semiconductor layer 351 can be an n+ amorphous silicon, the second type semiconductor layer can be an intrinsic amorphous silicon 353, the third type semiconductor layer 355 can be a p+ amorphous silicon, and the conductive contact layer 357 can be a metal, such as Mo.

Formation of the first, second and third type semiconductor layer 351, 353 and 355 can be achieved by the steps described in the following. First, an n+ type amorphous silicon layer 351 is deposited by chemical vapor deposition on the first electrode 334 and the first dielectric layer 348 overlying the sensitive area 306, and then an intrinsic amorphous silicon layer 353 is deposited by chemical vapor deposition on the n+ type amorphous silicon layer 351. Thereafter, the intrinsic amorphous silicon layer 353 is implanted with boron to form a p+ type amorphous silicon layer 355. Thus, the first, second and third type semiconductor layers 351, 353 and 355 constitute the photo sensor 210, for example, a P-I-N diode, as shown in FIG. 2.

Specifically, the first type semiconductor layer 351 can be about 400Ǻ~600Ǻ, the second type semiconductor layer 353 can be about 4000Ǻ~6000Ǻ, the third type semiconductor layer 355 can be about 400Ǻ~600Ǻ, and the conductive contact layer 357 can be about 400Ǻ~600Ǻ. However, the invention is not limited thereto. The diode 210 in FIG.2 can be a PN diode, comprising a first type semiconductor layer and a second type semiconductor layer, presenting a reverse type from a type of first type semiconductor layer. Further, the first, second and third type semiconductor layers 351, 353 and 355 can be replaced with any junction layer.

Referring to FIG. 3J, a second dielectric layer 359, such as silicon oxide, silicon nitride or silicon oxynitride, is formed on the first dielectric layer 348 and the conductive contact layer 357. Next, the first dielectric layer 348 and the second dielectric layer 359 are patterned by conventional photolithography and etching to form a plurality of openings 361, exposing the source 324, gate 330 and drain 326 of the n type transistor, the source 344, gate 332 and drain 346 of the p type transistor, and the conductive contact layer 357 overlying the sensitive area 306 respectively for connection to metal lines in subsequent processes. Next, referring to FIG. 3K, a metal layer (not shown) is blanketly deposited, and then patterned by conventional photolithography and etching to form conductive contacts 363 in the openings. Specifically, the conductive layer 357 in an opening 349 will be removed partially or entirely simultaneously during the etching process for forming the conductive contact 363.

Referring to FIG. 3L, a planarization layer 365, for example organic or oxide, is formed on the conductive contact layer 357 and the second dielectric layer 359. The planarization layer 365 can be about 10000Å~50000Å thick. The planarization layer 365 is patterned by conventional lithography and etching to form contact openings 367 corresponding to some of the conductive contacts 363. In an embodiment of the invention, the contact opening 367 exposes one of the conductive contacts 363 connecting the drain 346 of the p type transistor.

Referring to FIG. 3M, a pixel electrode layer (serving as an anode) 369, for example indium tin oxide (ITO), is formed on the planarization layer 365, electrically connecting the conductive contacts 363. Next, referring to FIG. 3N, a pixel definition layer 371, for example organic or oxide, is formed on a portion of the planarization layer 365 and the pixel electrode layer 369. Specifically, the pixel definition layer 371 exposes a portion of or the entire photo sensor.

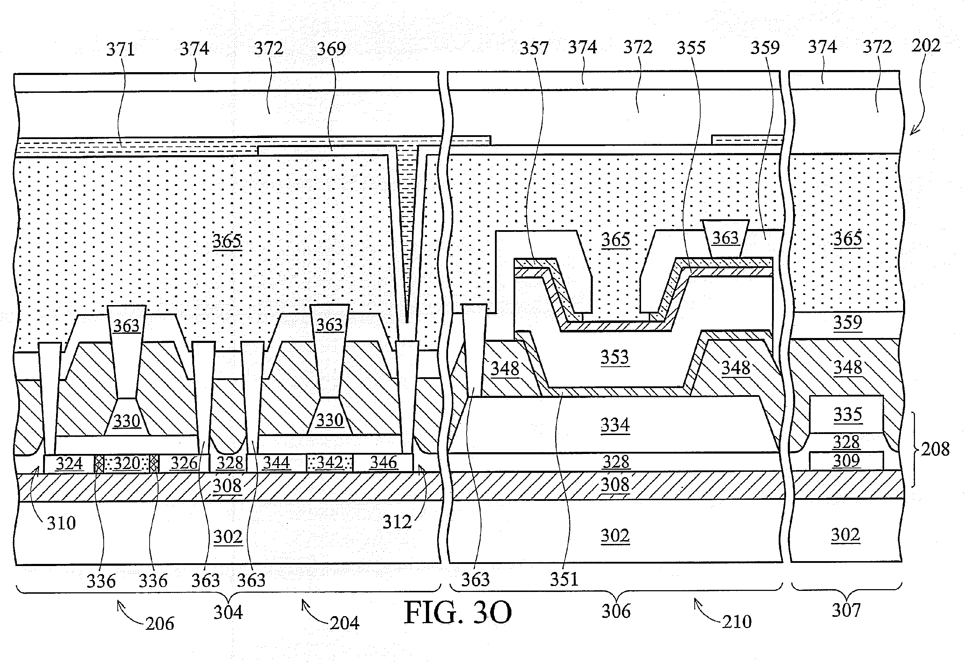

Referring to FIG. 30, an organic light emitting layer (OLED layer) 372 is formed overlying the pixel electrode layer 369 and the pixel definition layer 371. In an embodiment of the invention, the organic light emitting layer 372 disposed overlying the pixel electrode layer (also referred to as an anode layer or a first OLED electrode) comprises a hole-injection layer, a hole-transport layer, an organic luminescent material layer, an electron-transport layer, and an electron-injection layer sequentially. The anode layer can be indium tin oxide (In2O3:Sn, ITO) which has advantages of facile etching, low film-formation temperature and low resistance. When a bias voltage is applied to the OLED layer 372, an electron and a hole passing through the electron-transport layer and the hole-transport layer respectively enter the organic luminescent material layer to combine as an exciton and then release energy to return to ground state. Particularly, depending on the nature of the organic luminescent material, the released energy presents different colors of light including red (R), green (G) and blue (B).

Next, a cathode 374 is formed on the organic light emitting layer 372. The cathode 374 can be a reflective layer 374, for example Al, Ag or other suitable material with high reflectivity. Thus, the pixel electrode layer 369, the organic light emitting layer 372, and the cathode 374 constitute the organic electroluminescent element (OLED element) 202 as shown in FIG. 2. A bottom emission organic electroluminescent device is thus formed.

As shown in FIG. 2 and 30, in the described preferred embodiments of the invention, the first electrode 334, the first type semiconductor layer 351, the second type semiconductor layer 353, the third type semiconductor layer 355 and the conductive contact layer 357 constitute the vertical photo diode sensor 210. The p type transistor can act as a driving device 204 and the n type transistor can act as a switch device 206. Photo current is generated in the photo sensor 210. The level of photo current depends on the brightness of the OLED element 202. Consequently, voltage of a capacitor 208 coupled to the driving device 204 is adjusted to control the current passing through the driving device 204 according to illumination of the organic electroluminescent element 202 detected by the photo diode sensor 210, thus, illumination of the organic electroluminescent element 202 is changed for compensation. Therefore, after aging, brightness uniformity of the OLED element can be improved by such internal compensation.

Fig. 4 shows that the pixel element 20 shown in FIG. 2 or FIG. 30 can be incorporated into a displaly panel (in this case, display panel 30) that can be an OLED panel. The panel can form a portion of a variety of electronic devices (in this case, electronic device 50). Generally, the electronic device 50 comprises the OLED panel 30 and an input unit 40. Further, the input unit 40 is operatively coupled to the OLED panel 30 and provides input signals (e.g., image signal) to the panel 30 to generate image. The electronic device can be a mobile phone, digital camera, PDA (personal digital assistant), notebook computer, desktop computer, television, car display, or portable DVD player, for example.While the invention has been described by way of example and in terms of the preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An organic electroluminescent device, comprising:
a pixel element comprising:
a substrate, comprising a control area and a sensitive area;
a switch device and a driving device overlying the control area;
a photo diode overlying the sensitive area; and
an OLED element disposed in the sensitive area and illuminating the photo diode; and
a capacitor coupled to the photo diode and the driving device;
wherein a photo current corresponding to a brightness of the OLED element is generated by the photo diode responsive to the OLED element illuminating the photo diode such that a the voltage of the capacitor is adjusted by the photo current to control the current passing through the driving device, thus changing the illumination of the OLED element.

2. The organic electroluminescent device as claimed in claim 1, wherein the switch device and the driving device are top gate transistors.

3. The organic electroluminescent device as claimed in claim 1 or 2, wherein the photo diode is a vertical diode.

4. The organic electroluminescent device as claimed in claim 3, wherein the vertical diode comprises:
a first type semiconductor layer;
a third type semiconductor layer over the first type semiconductor layer; and
a second type semiconductor layer between the first and third type semiconductor layers, presenting a reverse type from a type of first type semiconductor layer.

5. The organic electroluminescent device as claimed in claim 4, wherein the first type semiconductor layer is an n+ amorphous silicon, the second type semiconductor layer is an intrinsic amorphous silicon, and the third type semiconductor layer is a p+ amorphous silicon.

6. The organic electroluminescent device as claimed in any of claims 3 to 5, wherein the vertical diode comprises:
a first type semiconductor layer; and
a second type semiconductor layer, presenting a reverse type from a type of first type semiconductor layer.

7. The organic electroluminescent device as claimed in any of claims 4 to 6, wherein the switch device has a first gate, the driving device has a second gate, and the photo diode has a first electrode connecting to the first type semiconductor layer, wherein the first gate of the switch device, the second gate of the driving device, and the first electrode of the photo diode are formed of the same layer.

8. The organic electroluminescent device as claimed in any of claims 1 to 7, further comprising:
a first active layer disposed in the switch device;
a second active layer disposed in the driving device;
a gate dielectric layer disposed overlying the first and second active layers and the sensitive area;
first and second gates disposed on the gate dielectric layer overlying the control area,
wherein the first gate is in the switch device, and the second gate is in the driving device;
a first electrode disposed on the gate dielectric layer overlying the sensitive area, wherein the first gate, the second gate, and the first electrode are of the same layer;
a first dielectric layer at least covering the first, second, and first electrode with a contact opening exposing a portion of the first electrode;
a P-I-N layer disposed on the first electrode and the first dielectric layer overlying the sensitive area; and
a conductive contact layer disposed on the P-I-N layer.

9. The organic electroluminescent device as claimed in claim 8, wherein the first dielectric layer further comprises a plurality of openings, exposing the first and second gates and a portion of the first and second active layers, and the openings are filled with conductive contacts.

10. The organic electroluminescent device as claimed in claim 9, further comprising:
a planarization layer disposed overlying the conductive contacts, the second dielectric layer, and the conductive contact layer;
a first OLED electrode overlying the planarization layer;
an organic light emitting layer disposed on the first electrode; and
a second OLED electrode disposed overlying the organic light emitting layer, wherein the first electrode, the organic light emitting layer and the second electrode constitutes the OLED element.

11. The organic electroluminescent device as claimed in any of claims 1 to 10, further comprising:
a display panel, wherein the pixel element is arranged in an array of pixel elements of the display panel.

12. The organic electroluminescent device as claimed in claim 11, further comprising an electronic device, wherein the electronic device comprises:
the display panel; and
an input unit coupled to the display panel and operative to provide input to the display panel such that they display panel displays images.

13. The organic electroluminescent device as claimed in claim 12, wherein the electronic device is a mobile phone, digital camera, PDA (personal digital assistant), notebook computer, desktop computer, television, car display, or portable DVD player.

14. An organic electroluminescent device, comprising:
a substrate, comprising a control area and a sensitive area;
a switch device and a driving device overlying the control area;
a photo diode overlying the sensitive area; and
an OLED element disposed in the sensitive area and illuminating the photo sensor; and
a capacitor coupled to the photo diode and the driving device;
wherein a photo current corresponding to a brightness of the OLED element is generated by the photo diode responsive to the OLED element illuminating the photo diode such that a the voltage of the capacitor is adjusted by the photo current to control the current passing through the driving device, thus changing the illumination of the OLED element,
wherein the switch device and the driving device are top gate transistors,
wherein the switch device has a first gate, the driving device has a second gate, and the photo diode has a first electrode connecting to the first type semiconductor layer,
wherein the first gate of the switch device, the second gate of the driving device, and the first electrode of the photo diode are formed of the same layer.

15. A method for forming an organic electroluminescent device, comprising:
providing a substrate, comprising a control area and a sensitive area;
forming a gate dielectric layer on the substrate;
forming a conductive layer on the gate dielectric layer;
patterning the conductive layer to form first and second gates in the control area, and a first electrode layer in the sensitive area;
forming a first dielectric layer at least covering the first gate, the second gate, and the first electrode layer;
patterning the first dielectric layer to form an opening down to the first electrode in the sensitive area;
forming a junction layer in the opening in the sensitive area; and
forming an OLED element overlying a portion of the control area and the sensitive area.

16. The method for forming an organic electroluminescent device as claimed in claim 15, wherein the junction layer comprises:
a first type semiconductor layer;
a third type semiconductor layer over the first type semiconductor layer; and
a second type semiconductor layer between the first and third type semiconductor layers, presenting a reverse type from a type of first type semiconductor layer.

17. The method for forming an organic electroluminescent device as claimed in claim 15, wherein the first type semiconductor layer is an n+ amorphous silicon, the second type semiconductor layer is an intrinsic amorphous silicon, and the third type semiconductor layer is a p+ amorphous silicon.
